# EUROPÄISCHE PATENTSCHRIFT

(11) **EP 1 203 410 B1**
(45) Veröffentlichungstag und Bekanntmachung des Hinweises auf die Patenterteilung: **02.11.2011**
(21) Anmeldenummer: 00954392.7
(22) Anmeldetag: 02.08.2000
(51) Int. Cl.: H01L 29/872, H01L 29/24

(54) **HALBLEITERERZEUGNIS MIT EINEM SCHOTTKY-KONTAKT**
PRODUCT WITH SEMICONDUCTOR COMPRISING A SCHOTTKY CONTACT
PRODUIT A SEMI-CONDUCTEUR COMPORTANT UN CONTACT SCHOTTKY

(30) Priorität: 06.08.1999 DE 19937198
(43) Veröffentlichungstag der Anmeldung: 08.05.2002
(73) Patentinhaber: Infineon Technologies AG, 85579 Neubiberg (DE)
(72) Erfinder: BARTSCH, Wolfgang, D-91054 Erlangen (DE); MITLEHNER, Heinz, D-91080 Uttenreuth (DE)
(74) Vertreter: Patentanwälte Westphal, Mussgnug & Partner
(86) Internationale Anmeldenummer: PCT/DE2000/002584
(87) Internationale Veröffentlichungsnummer: WO 2001/011692

(56) Entgegenhaltungen:
- WO-A-98/32177
- DE-U- 29 504 629
- US-A- 4 638 551

## Beschreibung

Die Anmeldung betrifft ein Halbleitererzeugnis, bei dem eine auf einen SiC-Halbleiterkörper eines ersten Leitfähigkeitstyps aufgebrachte Schottky-Kontaktschicht mit dem SiC-Halbleiterkörper einen Schottky-Kontakt bildet.

Die US 4 638 551 beschreibt eine Schottky-Diode, deren durch Metallisierung einer n-dotierten, Si-Epitaxieschicht gebildeter Schottky-Kontakt von zwei konzentrisch angeordneten und jeweils p-dotierten Ringzonen lateral begrenzt ist. Diese durch Bestrahlen einer entsprechend strukturierten Maske mit Dotierstoffionen erzeugten "Guard"-Ringe sollen den Verlauf des elektrischen Feldes in dieser Region verstetigen und gleichzeitig die elektrische Feldstärke herabsetzen.

Bei der aus der WO 98/32177 A1 bekannten Schottky-Diode ist der Schottky-Kontakt in der Driftzone des n-dotierten SiC-Substrats zwischen zwei durch Ionenimplantation erzeugten, jeweils p-dotierten Emitterregionen angeordnet. Benachbarte Emitterregionen sind hierbei durch eine, jeweils als ohmscher Kontakt wirkende Metallschicht leitend miteinander verbunden. Da die Metallschicht auch die zwischen den Emitterregionen liegende Driftzone abdeckt, bildet sie dort zusammen mit dem SiC-Substrat einen Schottky-Kontakt.

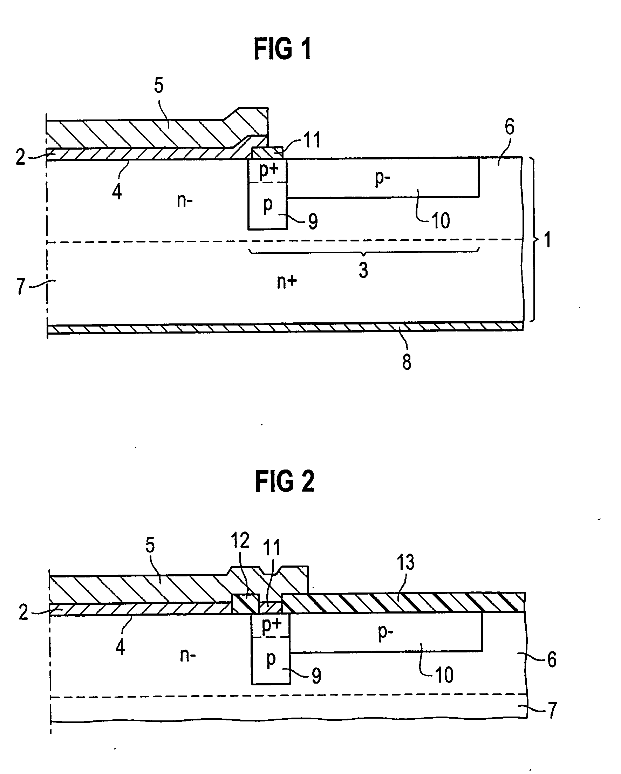

Gegenstand der WO 96/03774 A1 (siehe insbesondere Figur 2 nebst zugehöriger Beschreibung) ist eine Schottky-Diode für eine Anwendung bei einer hohen Sperrspannung und einem hohen Sperrstrom. Die bekannte Diode weist einen den eigentlichen Schottky-Kontakt umringenden, durch spezielle Dotierung in dem Körper geformten Randbereich auf, um am eigentlichen Schottky-Kontakt die Entstehung eines übermäßig hohen elektrischen Feldes zu vermeiden, welches die Spannungsfestigkeit des Halbleitererzeugnisses erheblich beeinträchtigen könnte.

Der vorliegend in Betracht zu ziehende Stand der Technik ergibt sich weiterhin aus der EP 0 380 340 A2, dem US-Patent 4,157,563 und der DE 38 32 748 A1. Außer dem US-Patent betreffen diese Dokumente insbesondere jeweils eine Schottky-Diode, realisiert in halbleitendem Siliziumcarbid, einem Halbleiter, welcher sich durch einen besonders hohen Bandabstand und weitere positive Eigenschaften auszeichnet.

Von Bedeutung ist auch das Buch "Power Semiconductor Devices" von B. J. Baliga, PWS Publishing Company, Boston, USA, 1995, siehe insbesondere das Kapitel 4 und dort den Abschnitt 4.3, Seiten 182 ff., wo eine Schottky-Diode beschrieben ist, die zwecks Verbesserung ihrer Spannungsfestigkeit zusätzlich Strukturen nach Art einer pn-Diode enthält, und das Buch "Modern Power Devices" von B. J. Baliga, Krieger Publishing Company, Malabar, Florida, USA, 1992, insbesondere das Kapitel 3.6, Seite 79ff., aus dem Hinweise zur Gestaltung eines Randabschlusses für ein besonders spannungsfestes Halbleitererzeugnis ersichtlich sind.

Hinweise zur Funktion eines Randabschlusses der beschriebenen Art in einer hochspannungsfesten Schottky-Diode sind auch erhältlich aus dem Buch "Metal-Semiconductor Contacts" von E. H. Rhoderick und R. H. Williams, 2. Auflage, Clarendon, Oxford, UK, 1988, siehe insbesondere die Figur auf Seite 131 nebst zugehöriger Beschreibung.

Zu allen vorstehend zitierten Dokumenten ist festzustellen, dass diese hinsichtlich der konkreten Auslegung eines Halbleitererzeugnisses stets nur Bezug nehmen auf die Problematik der Gewährleistung einer ausreichenden Sperrspannungsfestigkeit.

Weitere Ausführungsformen einer Schottky-Diode sind in der EP 0 803 913 A1, dem englischsprachigen Abstract zur JP 10-116999 A und dem englischsprachigen Abstract zur JP 60-128675 A beschrieben. Bei diesen Ausführungsformen ist jeweils innerhalb eines n-leitenden Körpers lateral neben einem Bereich, in dem der n-leitende Körper mit einer Kontaktschicht einen Schottky-Kontakt bildet, ein p-leitendes Gebiet angeordnet, das ebenfalls zumindest teilweise von der Kontaktschicht bedeckt ist.

Mit der US 5,789,911 wird ein Verfahren zur Herstellung einer Schottky-Diode aus n-leitendem Siliziumcarbid offenbart. Der n-leitende Siliziumcarbid-Körper bildet mit einer an seiner Oberfläche angeordneten p-leitenden Siliziumcarbid-Schicht einen pn-Übergang.

Eine Schottky-Diode aus Siliziumcarbid findet zunehmend Interesse zur Anwendung in einer Hochleistungs-Schaltanlage oder einem Schaltnetzteil. In einer solchen Anwendung ist eine Schottky-Diode allerdings nicht nur einer hohen Sperrspannungsbelastung unterworfen, sondern zumindest gelegentlich auch einer sehr hohen Belastung durch Strom, der die Schottky-Diode in Durchlassrichtung durchquert. Insbesondere dann, wenn über die Schottky-Diode erstmalig ein Speicherkondensator aufgeladen werden soll, muss damit gerechnet werden, dass die Diode von einem Strom durchflossen wird, welcher einen Nennstrom, für den die Diode eigentlich ausgelegt ist, um ein großes Vielfaches überschreitet; ein solcher "Stoßstrom" kann mehr als das Hundertfache des Nennstroms, welcher im Rahmen des regulären Betriebs üblicherweise nicht überschritten wird, betragen. Eine funktionsgerechte Auslegung einer Schottky-Diode sollte dementsprechend auch die Möglichkeit der gelegentlichen Überlastung durch einen den Nennstrom wesentlich überschreitenden Stoßstrom in Betracht ziehen. Eine entsprechende Erwägung ist dem vorliegenden Stand der Technik allerdings nicht zu entnehmen.

Dementsprechend liegt der Erfindung die Aufgabe zugrunde, ein Halbleitererzeugnis mit einem Schottky-Kontakt anzugeben, in dem die Durchleitung eines das Halbleitererzeugnis kurzzeitig überlastenden Stroms von der Höhe eines vorgegebenen Stoßstroms in kontrollierter Weise erfolgt.

Gelöst wird diese Aufgabe durch ein Halbleitererzeugnis, welches die in Patentanspruch 1 angegebenen Merkmale aufweist.

In dem Halbleitererzeugnis ist dementsprechend eine dem Schottky-Kontakt parallelgeschaltete pn-Diode vorgesehen. Diese Diaode wird gebildet durch ein im n-dotierten SiC-Halbleiterkörper lateral neben dem Schottky-Kontakt angeordnetes p-dotiertes erstes Gebiet, welches über eine ohmsche Kontaktschicht mit der Schottky-Kontaktschicht in leitender Verbindung steht. Diese pn-Diode hat prinzipiell eine höhere Schleusenspannung als der Schottky-Kontakt und ist bei einem Betrieb des Erzeugnisses mit einem durchfließenden Strom in auslegungsgemäß niedriger Höhe somit außer Funktion. Fließt ein den Schottky-Kontakt überlastender Strom, so erhöht sich der über dem Schottky-Kontakt anstehende Spannungsabfall aufgrund des inhärenten positiven Temperaturkoeffizienten und setzt bei Überschreitung der Schleusenspannung der pn-Diode diese in ihren leitenden Zustand. So wird einerseits der Schottky-Kontakt entlastet und andererseits der Fluss des überlastenden Stroms kontrolliert - er bleibt beschränkt auf die pn-Diode, welche aufgrund ihres inhärenten negativen Temperaturkoeffizienten den überlastenden Strom zunehmend von dem Schottky-Kontakt übernimmt.

Damit ist insbesondere vermieden, dass sich das Halbleitererzeugnis bei einer Belastung entsprechend dem Stoßstrom unkontrolliert und unvorhersehbar erwärmt und möglicherweise einen Schaden hervorruft, nicht nur an sich selbst, sondern auch an einer Schaltung, in die es eingebunden ist. Das Halbleitererzeugnis vereinigt in sich die positiven Eigenschaften einer Schottky-Diode im regulären Betrieb und die positiven Eigenschaften einer pn-Diode bei kurzfristiger Überlastung.

Weiterhin ist das lateral neben dem Schottky-Kontakt angeordnete erste Gebiet inhomogen dotiert mit einer Dotierungsdichte, welche an der ohmschen Kontaktschicht ein Maximum hat. So ist eine besonders gute Kontaktierung der dem Schottky-Kontakt parallelgeschalteten pn-Diode sichergestellt. Es sei bemerkt, dass sich eine entsprechende Dotierungsdichte weitgehend von selbst ergibt, wenn für den aus Siliziumcarbid bestehenden Halbleiterkörper Aluminium sowohl für die Dotierung des ersten Gebiets als auch zur Bildung der ohmschen Kontaktschicht verwendet wird - die Dotierungsdichte ist durch Interdiffusion zwischen der Kontaktschicht und dem Körper erreichbar.

Dadurch, dass der Schottky-Kontakt und das erste Gebiet von einem Randabschluss umfassend ein in dem zweiten Leitfähigkeitstyp dotiertes zweites Gebiet in dem Körper umringt sind, erhält das Erzeugnis zusätzlich eine vorgebbare Spannungsfestigkeit.

Die Schottky-Kontaktschicht besteht aus einem je nach Art des halbleitenden Körpers und seiner Dotierung speziell auszuwählenden Metall; für einen n-leitfähig dotierten Körper aus Siliziumcarbid kommen dazu insbesondere Titan, Tantal, Chrom und Nickel in Frage. Die Dicke der Schottky-Kontaktschicht kann in der Regel gering bleiben; eine typische Dicke beträgt 150 nm.

Vorzugsweise reicht das erste Gebiet bis zu einer ersten Tiefe in den Körper hinein, wobei die erste Tiefe größer ist als eine zweite Tiefe, bis zu der das zweite Gebiet in den Körper hineinreicht. Derart ist sichergestellt, dass ein das Erzeugnis überlastender Strom, der in das erste Gebiet eindringt, nicht in das zweite Gebiet gelangt; auch wird so verhindert, dass sich ein unzuträglich starkes elektrisches Feld an dem zweiten Gebiet bildet.

Besonders bevorzugt wird eine Ausbildung des Halbleitererzeugnisses, bei der das erste Gebiet den Schottky-Kontakt umringt; dadurch wird eine besonders hoch belastbare pn-Diode erreicht.

Der Körper des Halbleitererzeugnisses ist vorzugsweise aufgeteilt in eine an den Schottky-Kontakt angrenzende epitaktische Schicht und ein dem Schottky-Kontakt abgewandtes Substrat, welches stärker dotiert ist als die Schicht. Derart gewährleistet die Schicht mit ihrer relativ niedrigen Dotierung eine hohe Sperrfähigkeit und das Substrat mit seiner relativ hohen Dotierung einen relativ niedrigen Durchgangswiderstand des Halbleitererzeugnisses. Das Substrat ist weiter vorzugsweise mit einem ohmschen Kontakt kontaktiert, so dass die Schottky-Kontaktschicht und dieser ohmsche Kontakt die Anschlüsse des Halbleitererzeugnisses zur Einbindung in eine externe Schaltung darstellen.

Das Substrat des Halbleitererzeugnisses ist ein Kristall aus Siliziumcarbid. Siliziumcarbid als ein Halbleiter mit hohem Bandabstand hat vorliegend den zusätzlichen Vorteil, dass die neben der Schottky-Diode vorgesehene pn-Diode erst bei einer vergleichsweise hohen Spannung zu leiten beginnt und dementsprechend die Funktion des Schottky-Kontaktes im regulären Betrieb praktisch nicht beeinträchtigt.

Die Schottky-Kontaktschicht des Halbleitererzeugnisses ist vorzugsweise bedeckt mit einer leitfähigen Kontaktverstärkungsschicht, insbesondere gebildet aus einem entsprechend gebräuchlichen Metall wie Aluminium. Die Kontaktverstärkungsschicht erleichtert die Kontaktierung der Schottky-Kontaktschicht durch Bonden, Löten, Klemmen und andere gebräuchliche Kontaktierungen. Die Kontaktverstärkungsschicht verbindet vorzugsweise die Schottky-Kontaktschicht mit der ohmschen Kontaktschicht.

Ausführungsbeispiele der Erfindung werden nunmehr anhand der Zeichnung erläutert. Alle Figuren der Zeichnung sind als schematische Skizzen anzusehen; es wird nicht geltend gemacht, dass die Zeichnung eine maßstabsgerechte Wiedergabe eines Ausführungsbeispiels enthalte.

Die Figuren 1 und 2 der Zeichnung zeigen schematische Schnitte von Ausführungsbeispielen. Einander entsprechende Bestandteile der Figuren sind jeweils mit demselben Bezugszeichen bezeichnet.

Figur 1 zeigt ein Halbleitererzeugnis umfassend einen Körper 1 aus einem Halbleiter, und zwar n-leitfähig dotiertem Siliziumcarbid, und eine darauf aufgebrachte Schottky-Kontaktschicht 2. Diese besteht aus einer etwa 150 nm dicken Schicht aus Titan und bildet mit dem Körper 1 einen von einem Randbereich 3 umgebenen und berandeten Schottky-Kontakt 4. Die Schottky-Kontaktschicht 2 ist bedeckt von einer Kontaktverstärkungsschicht 5 aus Aluminium zur Verbesserung der thermischen und elektrischen Kontaktierung der Schottky-Kontaktschicht 2. Der Körper 1 ist aufgeteilt in eine dem Schottky-Kontakt 4 zugewandte epitaktische Schicht 6 und ein dem Schottky-Kontakt 4 abgewandtes Substrat 7, welches stärker dotiert ist als die darauf aufgewachsene Schicht 6. Die relativ geringe Dotierung der Schicht 6 gewährleistet eine hohe Sperrfähigkeit und die relativ hohe Dotierung des Substrates 7 einen geringen Durchlasswiderstand des Halbleitererzeugnisses. Auf dem Substrat 7 befindet sich auch ein ohmscher Kontakt 8 aus einem herkömmlichen Metall, welcher als Kathode des Halbleitererzeugnisses dient. Die Anode des Halbleitererzeugnisses ist gegeben durch die Schottky-Kontaktschicht 2 bzw. die Kontaktverstärkungsschicht 5. Der Randbereich 3 des Halbleitererzeugnisses umfasst ein dem Schottky-Kontakt 4 direkt zugewandtes erstes Gebiet 9 und ein dem Schottky-Kontakt 4 abgewandtes zweites Gebiet 10. Das erste Gebiet 9 ist zumindest teilweise stärker dotiert als das zweite Gebiet 10 und reicht auch tiefer in das Substrat 1 hinein; es bildet mit dem Substrat 1 eine pn-Diode, welche bei einer Überlastung des Halbleitererzeugnisses mit einem durchfließenden Strom einen Teil des überlastenden Stromes übernimmt und den Schottky-Kontakt 4 entlastet. Für eine zuverlässige Kontaktierung an eine ohmsche Kontaktschicht 11 ist in deren Nähe eine relativ hohe Dotierung des ersten Gebietes 9 erforderlich, wie angedeutet durch das Symbol "p+". Das erste Gebiet 9 ist mit der Schottky-Kontaktschicht 2 verbunden über die ohmsche Kontaktschicht 11; dass vorliegend auch die Schottky-Kontaktschicht 2 das erste Gebiet 9 direkt kontaktiert, ist funktionell unerheblich.

Figur 2 zeigt eine Weiterbildung des Ausführungsbeispiels gemäß Figur 1. Dabei ist vorgesehen, dass die Schottky-Kontaktschicht 2 und die ohmsche Kontaktschicht 11 durch eine erste Isolierschicht 12 voneinander distanziert sind und ihre elektrische Verbindung über die entsprechend ausgedehnte Kontaktverstärkungsschicht 5 gegeben ist. Außerdem vorgesehen ist eine zweite Isolierschicht 13, welche zur Passivierung des Halbleitererzeugnisses außerhalb des Bereiches des Schottky-Kontaktes 4 dient.

Die konkrete Auslegung eines realen Halbleitererzeugnisses entsprechend einem der skizzierten Ausführungsbeispiele bedarf in der Regel der Anwendung der dem einschlägig tätigen Fachmann geläufigen Simulationstechnik, um die Abmessungen und weiteren Kenngrößen aller Bestandteile des Halbleitererzeugnisses auszuwählen und aneinander anzupassen.

Ein konkret zur Produktion in Betracht genommenes Ausführungsbeispiel ist ausgelegt für einen regulären Strom von etwa 4 Ampere und soll kurzzeitig, typisch für einen Zeitraum von 10 Mikrosekunden, einen mittleren Stoßstrom von 120 Ampere in der beschriebenen Weise leiten können. Für einen längeren Zeitraum von 3 Millisekunden wird ein gemittelter Stoßstrom von 60 Ampere in Betracht gezogen. Der Schottky-Kontakt 4 ist kreisförmig mit einem Durchmesser von 1,4 Millimetern; das kreisringförmig ausgelegte und direkt an den Schottky-Kontakt 4 anschließende erste Gebiet 9 hat eine Breite zwischen 100 und 150 Mikrometern. Die Schleusenspannung des Schottky-Kontakts 4 liegt bei etwa 1 Volt, die Schleusenspannung der pn-Diode zwischen 2,4 Volt und 3 Volt. Funktionell wird die über diesem Halbleitererzeugnis anstehende elektrische Spannung bei Überlastung durch die leitfähig werdende pn-Diode begrenzt auf einen Wert zwischen 2,4 Volt und 3 Volt. Die Sperrfähigkeit des Halbleitererzeugnisses ist durch die Auslegung im Hinblick auf den Stoßstrom in keiner Weise beeinträchtigt, denn die herkömmlichen Mittel, wie speziell dotierte Ringe nach Art eines zweiten Gebietes 10 und Feldplatten stehen zur Verfügung; siehe insoweit den zitierten Stand der Technik. Das konkret in Betracht genommene Ausführungsbeispiel ist dimensioniert für eine Sperrspannung von 600 V; dazu benötigt das zweite Gebiet 10 eine Breite von etwa 40 Mikrometern. Einzubauen ist dieses Halbleitererzeugnis in ein herkömmliches Gehäuse des Typs TO 220.

Die Erfindung ermöglicht die Realisierung einer Schottky-Diode, die sowohl im Hinblick auf ihre Sperrfähigkeit als auch im Hinblick auf ihre Überlastbarkeit durch einen Stoßstrom besonders günstige Eigenschaften besitzt.

## Patentansprüche

1. Halbleitererzeugnis mit den folgenden Merkmalen:
eine auf einem SiC Halbleiterkörper der ein Kristall aus Siliziumkarbid ist (1) eines ersten Leitfähigkeitstyps aufgebrachte Schottky-Kontaktschicht (2), die mit dem SiC-Halbleiterkörper (1) einen Schottky-Kontakt bildet (4);
ein erstes Gebiet (9) eines zweiten Leitfähigkeitstyps der den ersten leitfähigkeitstyp entgegengesetzt ist, dass im SiC-Halbleiterkörper (1) lateral neben dem Schottky-Kontakt (4) angeordnet ist, das über eine ohmsche Kontaktschicht (11) mit der Schottky-Kontaktschicht (2) leitend verbundene erste Gebiet (9) derart inhomogen dotiert ist, dass die Dotierungsdichte an der ohmschen Kontaktschicht (11) ein Maximum aufweist; und wobei
der Schottky-Kontakt (4) und das erste Gebiet (9) von einem im SiC-Halbleiterkörper (1) vorhandenen zweiten Gebiet (10) des zweiten Leitfähigkeitstyps als Randabschluss umringt sind.

2. Halbleitererzeugnis nach Anspruch 1, **dadurch gekennzeichnet,**
**dass** das erste Gebiet (9) tiefer in den SiC-Halbleiterkörper (1) hineinreicht als das zweite Gebiet (10).

3. Halbleitererzeugnis nach Anspruch 1 oder 2, **dadurch gekennzeichnet, dass**
das erste Gebiet (9) den Schottky-Kontakt (4) ringförmig umschließt.

4. Halbleitererzeugnis nach einem der vorigen Ansprüche, **dadurch gekennzeichnet, dass**
der SiC-Halbleiterkörper (1) aufgeteilt ist in eine an den Schottky-Kontakt (4) angrenzende epitaktische Schicht (6) und ein dem Schottky-Kontakt (4) abgewandtes Substrat (7), welches stärker dotiert ist als die epitaktische Schicht (6).

5. Halbleitererzeugnis nach Anspruch 4, bei dem das Substrat (7) mit einem ohmschen Kontakt (8) kontaktiert ist.

6. Halbleitererzeugnis nach einem der vorigen Ansprüche, **dadurch gekennzeichnet, dass**
die Schottky-Kontaktschicht (2) ihrerseits von einer leitfähigen Kontaktverstärkungsschicht (5) bedeckt ist.

7. Halbleitererzeugnis nach Anspruch 6, **dadurch gekennzeichnet, dass**
die Kontaktverstärkungsschicht (5) die Schottky-Kontaktschicht (2) mit der ohmschen Kontaktschicht (11) verbindet.

## Claims

1. Semiconductor product comprising the following features:
a Schottky contact layer (2) applied on an SiC semiconductor body (1) - which is a crystal composed of silicon carbide - of a first conductivity type, said Scottky contact layer forming a Schottky contact (4) with the SiC semiconductor body (1);
a first region (9) of a second conductivity type, which is opposite to the first conductivity type, said first region being arranged in the SiC semiconductor body (1) laterally beside the Schottky contact (4), wherein the first region (9), which is conductively connected to the Schottky contact layer (2) via an ohmic contact layer (11), is doped inhomogeneously in such a way that the doping density has a maximum at the ohmic contact layer (11); and wherein
the Schottky contact (4) and the first region (9) are surrounded by a second region (10) of the second conductivity type, said second region being present in the SiC semiconductor body (1), as an edge termination.

2. Semiconductor product according to Claim 1, **characterized in that** the first region (9) reaches down more deeply into the SiC semiconductor body (1) than the second region (10).

3. Semiconductor product according to Claim 1 or 2, **characterized in that** the first region (9) surrounds the Schottky contact (4) in ring-shaped fashion.

4. Semiconductor product according to one of the preceding claims, **characterized in that** the SiC semiconductor body (1) is divided into an epitaxial layer (6) adjoining the Schottky contact (4) and a substrate (7) which is remote from the Schottky contact (4) and is doped more heavily than the epitaxial layer (6).

5. Semiconductor product according to Claim 4, in which the substrate (7) is contact-connected with an ohmic contact (8).

6. Semiconductor product according to one of the preceding claims,
**characterized in that** the Schottky contact layer (2) is for its part covered by a conductive contact reinforcing layer (5).

7. Semiconductor product according to Claim 6,
**characterized in that** the contact reinforcing layer (5) connects the Schottky contact layer (2) to the ohmic contact layer (11).

## Revendications

1. Produit à semi-conducteur ayant les caractéristiques suivantes :
une couche (2) de contact de Schottky déposée sur un corps (1) semi-conducteur en SiC,, qui est un cristal en carbure de silicium d'un premier type de conductivité, qui forme avec le corps (1) semi-conducteur en SiC, un contact (4) de Schottky,
une première zone (9) d'un deuxième type de conductivité, qui est opposée au premier type de conductivité, qui est disposée dans le corps (1) semi-conducteur en SiC latéralement à côté du contact (4) de Schottky, la première zone, (9) reliée d'une manière conductrice à la couche (2) de contact de Schottky par une couche (11) de contact ohmique, étant dopée de manière non homogène de façon à ce que la densité de dopage ait un maximum sur la couche (11) de contact ohmique et dans lequel
le contact (4) de Schottky et la première zone (9) sont entourés en tant que fermeture de bord d'une deuxième zone (10) du deuxième type de conductivité présente dans le corps (1) semi-conducteur en SiC.

2. Produit à semi-conducteur suivant la revendication 1, **caractérisé**
**en ce que** la première zone (9) pénètre plus profondément dans le corps (1) semi-conducteur en SiC que la deuxième zone (10).

3. Produit à semi-conducteur suivant la revendication 1 ou 2, **caractérisé**
**en ce que** la première zone (9) entoure annulairement le contact (4) de schottky.

4. Produit à semi-conducteur suivant l'une des revendications précédentes, **caractérisé**
**en ce que** le corps (1) semi-conducteur en SiC est subdivisé en une couche (6) épitaxiale voisine du contact (4) de Schottky et en un substrat (7) qui est éloigné du contact (4) de Schottky et qui est dopé plus fortement que la couche (6) épitaxiale.

5. Produit à semi-conducteur suivant la revendication 4, dans lequel le substrat (7) est mis en contact avec un contact (8) ohmique.

6. Produit à semi-conducteur suivant l'une des revendications, **caractérisé**
**en ce que** la couche (2) de contact de Schottky est revêtue de son côté d'une couche (5) conductrice de renforcement du contact.

7. Produit à semi-conducteur suivant la revendication 6, **caractérisé**
**en ce que** la couche (5) de renforcement du contact relie la couche (2) de contact de Schottky à la couche (11) de contact ohmique.
